# EUROPEAN PATENT APPLICATION

(11) **EP 4 387 040 A1**
(43) Date of publication of application: **19.06.2024**
(21) Application number: 22863423.4
(22) Date of filing: 30.08.2022
(51) Int. Cl.: H02J 7/00, H05K 7/20, H05K 5/02

(54) **MULTI-SLOT CHARGER**

(30) Priority: 01.09.2021 CN 202122103906 U; 01.09.2021 CN 202111023695; 01.09.2021 CN 202122099208 U; 01.09.2021 CN 202111019995; 01.09.2021 CN 202122099210 U; 01.09.2021 CN 202111024536; 01.09.2021 CN 202122099217 U; 01.09.2021 CN 202111023247; 01.09.2021 CN 202122093559 U; 01.09.2021 CN 202111023470
(71) Applicant: Globe (Jiangsu) Co., Ltd., Changzhou, Jiangsu 213023 (CN)
(72) Inventor: XIE, Xuyan, hangzhou, Jiangsu 213023 (CN); LI, Xi, hangzhou, Jiangsu 213023 (CN); YAN, An, hangzhou, Jiangsu 213023 (CN); HUO, Xiaohui, hangzhou, Jiangsu 213023 (CN); GAO, Naixin, hangzhou, Jiangsu 213023 (CN)
(74) Representative: Bergenstråhle & Partners AB
(86) International application number: PCT/CN2022/115694
(87) International publication number: WO 2023/030288

(57) **Abstract**

A multi-slot charger can be placed in a vertical, horizontal, or wall-mounted manner. The charger includes a housing and a handle assembly. The handle assembly includes auxiliary handles on two sides of the housing and a lifting handle provided on the top of the housing. The auxiliary handles support the multi-slot charger when the multi-slot charger is placed vertically and/or horizontally. When the multi-slot charger is wall-mounted, a plurality of locking slots is provided on the housing such that the housing can be directly connected to a vertical surface through the plurality of locking slots, or a wall-mounting bracket is installed on the housing such that the housing charger can be fastened to the vertical surface through the wall-mounting bracket.

## Description

### TECHNICAL FIELD

The present disclosure belongs to the technical field of chargers, and in exemplary embodiments relates to multi-slot charger.

### BACKGROUND

In recent years, with the development of battery material technology, the application scope of lithium batteries has been greatly expanded. At present, power tool products on the market have been widely used. In today's power tool industry, lithium battery packs have become an unstoppable alternative to traditional energy sources as an emerging power source. Lithium battery packs are used more and more widely, and the requirements for their battery life and charging time are also getting higher and higher.

However, there are many problems with the current chargers. For example, the current chargers can only charge one to one, and the charging time greatly affects the work efficiency. In addition, when a large number of battery packs are charged separately, a large storage space is required, which brings great trouble to production and processing. Traditional chargers can generally only be placed vertically on the ground, which is more troublesome to use in some special usage scenarios. The heat dissipation effect of traditional chargers is poor. The handle of traditional chargers is directly fixed on the charger housing with screws, the force is concentrated on the screw fixing point, the force-bearing area is too small, and the housing is easily damaged.

In view of the above, it is necessary to improve existing chargers to solve the above problems.

### SUMMARY

The present disclosure proposes a multi-slot charger. The multi-slot charger can be placed vertically, horizontally, or in a wall-mounted way.

The multi-slot charger includes a housing and a handle assembly including auxiliary handles provided on two sides of the housing and a lifting handle provided on a top of the housing.

When the multi-slot charger is placeable in a vertical and/or horizontal manner, the auxiliary handles are configured to support the multi-slot charger.

When the multi-slot charger is placeable in a wall-mounted manner, a plurality of locking slots is provided on the housing such that the housing is directly connectable to a vertical surface through the plurality of locking slots, or a wall-mounting bracket is installed on the housing such that the housing is able to be mountable to the vertical surface through the wall-mounting bracket.

In exemplary embodiments of the present disclosure, the wall-mounting bracket includes a back panel and a bottom panel, and the back panel is fixedly connected to the bottom panel.

In exemplary embodiments of the present disclosure, the back panel is configured to cover a second case of the housing, and the bottom panel is configured to support and cover a bottom surface of the housing.

In exemplary embodiments of the present disclosure, the back panel is provided with location holes near the top of two sides of the back panel, the location holes are located on a same straight line, and the housing is installed on the wall-mounting bracket through the location holes.

In exemplary embodiments of the present disclosure, the back panel is further provided with a plurality of mounting holes evenly distributed on the back panel, and the wall-mounting bracket is installed on the vertical surface through the plurality of mounting holes.

In exemplary embodiments of the present disclosure, the wall-mounting bracket further includes side panels configured to cover the auxiliary handles on two sides of the housing, second bottom surfaces are formed extending inwardly from the side panels, and the second bottom surfaces are configured to support the auxiliary handles.

In exemplary embodiments of the present disclosure, the bottom panel and the second bottom surfaces are all rigid force-bearing surfaces.

In exemplary embodiments of the present disclosure, a plurality of ventilation slots is provided on the bottom panel at intervals and the plurality of ventilation slots corresponds in a one-to-one manner to vents on a bottom of the housing.

In exemplary embodiments of the present disclosure, the multi-slot charger is provided with a switch configured to control and switch the charging mode of the multi-slot charger.

In exemplary embodiments of the present disclosure, the multi-slot charger further includes a plurality of charging slot indicator lights, and the plurality of charging slot indicator lights being disposed on the top of the housing and located below the lifting handle of the handle assembly.

In exemplary embodiments of the present disclosure, the ratio of the vertical distance between a front side of the auxiliary handle and a midline of the lifting handle to the vertical distance between a rear side of the auxiliary handle and the midline of the lifting handle is between 1 and 3.

In exemplary embodiments of the present disclosure, when a battery pack is installed on the multi-slot charger, the ratio of a total weight of the battery pack to a weight of the multi-slot charger is between 0.1 and 4.

In exemplary embodiments of the present disclosure, the housing is provided with a plurality of charging slots, and each charging slot includes a charging interface and a power supply terminal to match a battery pack.

In exemplary embodiments of the present disclosure, there is an angle β between the charging interface and the vertical direction of the multi-slot charger, and the range of the angle β is 0 ° to 60°.

In exemplary embodiments of the present disclosure, a spacing distance between two adjacent battery packs is provided on the charging interface, and the spacing distance ranges from 3 mm to 100 mm.

In exemplary embodiments of the present disclosure, the housing includes a first case and a second case, the first case and the second case are fixedly connected, the charging slot is located on the first case, and an inner wall of the second case is provided with horizontal and vertical grid-shaped reinforcing ribs.

In exemplary embodiments of the present disclosure, a bottom surface of the multi-slot charger has a slope structure, and a direction of the slope structure is inclined downwardly relative to a direction pointing from the first case to the second case.

In exemplary embodiments of the present disclosure, an angle between the slope structure and the ground is between 3° and 6°, and a spacing distance between a lowest point of the slope structure and the ground is between 5 mm and 20 mm.

In exemplary embodiments of the present disclosure, the lifting handle includes a main part and flat structures at two ends, the main part extends toward the housing to form two connecting posts, each connecting post extends into the interior of the housing and is fixedly connected to the housing through a reinforcing plate, and the flat structures are configured to be fixedly connected to the auxiliary handles on two sides of the housing.

In exemplary embodiments of the present disclosure, the housing is provided with a heat dissipation structure. The heat dissipation structure includes a plurality of first vents provided at the bottom of the housing of the multi-slot charger; and a plurality of second vents provided on the top of the housing, wherein a ratio of an area of the first vent and an area of the second vent is between 1 and 2; and a plurality of cooling fans provided in the housing and correspond to the plurality of second vents in a one-to-one manner.

Some exemplary embodiments of the present disclosure propose a multi-slot charger. The multi-slot charger uses a variety of different ways of placement, so that different ways of placement may be adopted in different usage scenarios. Therefore, the multi-slot charger may be used more rationally.

Some exemplary embodiments of the present disclosure propose a multi-slot charger. By configuring multiple charging slots on the charger, multiple battery packs may be charged at the same time, thereby improving the charging efficiency. In addition, the multi-slot charger is configured with two different charging modes, and users may switch between different charging modes to charge the battery pack according to their needs under different circumstances.

Some exemplary embodiments of the present disclosure propose a multi-slot charger, a certain distance is provided between each two adjacent charging slots to facilitate the installation of battery packs. The battery packs installed on the charging slots are also arranged at intervals, which are used as safe distances during the charging process of the battery packs to prevent two adjacent battery packs from being too close and causing collision and scratches during the insertion or removal process.

Some exemplary embodiments of the present disclosure propose a multi-slot charger. By configuring multiple charging slots on the charger, multiple battery packs may be charged at the same time, thereby improving the charging efficiency. In addition, the multi-slot charger is configured with two different charging modes, and users may switch between different charging modes to charge the battery pack according to their needs under different circumstances. The present disclosure proposes a multi-slot charger, a certain distance is provided between each two adjacent charging slots to facilitate the installation of battery packs. The battery packs installed on the charging slots are also arranged at intervals, which are used as safe distances during the charging process of the battery packs to prevent two adjacent battery packs from being too close and causing collision and scratches during the insertion or removal process. In addition, the adaptability of the multi-slot charger is enhanced by configuring different charging interfaces in the charging slots to adapt to different battery packs.

Some exemplary embodiments of the present disclosure propose a multi-slot charger. A charging interface is configured in the multi-slot charger. An angle is provided between the charging interface and the vertical direction of the multi-slot charger. The existence of the angle facilitates the cooperative installation between the battery packs and the charging interfaces.

Some exemplary embodiments of the present disclosure propose a handle assembly for a multi-slot charger and a multi-slot charger. By providing a handle assembly instead of directly fixing the handle to the first case and/or the second case of the multi-slot charger with screws, the force is prevented from being concentrated on the screw fixation, thereby avoiding the situation that the housing is easily damaged because the force-bearing area is too small. In the present disclosure, the area where the first auxiliary handle and the second auxiliary handle in the handle assembly are connected to the multi-slot charger completely covers and secures the end faces of the first case and/or the second case of the multi-slot charger and then the handle is connected and fixed. This structure may increase the stressed area and make the whole structure stronger and more reliable.

Some exemplary embodiments of the present disclosure propose a heat dissipation structure for a multi-slot charger and a multi-slot charger. A first vent and a second vent are provided on the housing, and at least two heat sinks are provided on the circuit board assembly. Two heat sinks form the air duct body, and a cooling fan is installed on the circuit board assembly and located at the air duct body. The first vent, the second vent, and the cooling fan are in a one-to-one correspondence and facing the air duct body to enhance its ventilation effect and thereby enhance its heat dissipation effect.

### BRIEF DESCRIPTION OF DRAWINGS

In order to explain the technical solutions of the embodiments of the present disclosure more clearly, the drawings needed to describe the embodiments will be briefly introduced below. Obviously, the drawings in the following description are only some embodiments of the present disclosure. For those of ordinary skill in the art, other drawings can also be obtained based on these drawings without exerting creative efforts.
FIG. 1 is a schematic structural diagram of a multi-slot charger according to exemplary embodiments of the present disclosure;
FIG. 2 is a front view of a housing of a multi-slot charger according to exemplary embodiments of the present disclosure;
FIG. 3 is a schematic diagram of the spacing between battery packs according to exemplary embodiments of the present disclosure;
FIG. 4 is a side view of a multi-slot charger according to exemplary embodiments of the present disclosure;
FIG. 5 is a rear view of a multi-slot charger according to exemplary embodiments of the present disclosure;
FIG. 6 is a bottom view of a housing of a multi-slot charger according to exemplary embodiments of the present disclosure;
FIG. 7 is a schematic structural diagram of an axial side of a housing of a multi-slot charger according to exemplary embodiments of the present disclosure;
FIG. 8 is a schematic structural diagram of a multi-slot charger with a first case removed according to exemplary embodiments of the present disclosure;
FIG. 9 is a schematic structural diagram of a circuit board and a socket assembly of a multi-slot charger according to exemplary embodiments of the present disclosure;
FIG. 10 is a schematic structural diagram of a multi-slot charger with a second case removed according to exemplary embodiments of the present disclosure;
FIG. 11 is a top view of a housing of a multi-slot charger according to exemplary embodiments of the present disclosure;
FIG. 12 is a bottom view of a housing of a multi-slot charger according to exemplary embodiments of the present disclosure;
FIG. 13 is a schematic assembly diagram of a multi-slot charger and battery packs according to exemplary embodiments of the present disclosure;
FIG. 14 is a second side view of a multi-slot charger according to exemplary embodiments of the present disclosure;
FIG. 15 is a schematic structural diagram of a socket assembly in a multi-slot charger according to exemplary embodiments of the present disclosure;
FIG. 16 is a schematic assembly diagram of a metal inlay and a charging interface in a multi-slot charger according to exemplary embodiments of the present disclosure;
FIG. 17 is an exploded schematic diagram of a metal inlay and a charging interface in a multi-slot charger according to exemplary embodiments of the present disclosure;
FIG. 18 is a partial cross-sectional view along F-F in FIG. 16;
FIG. 19 is a schematic assembly diagram of a battery pack and a charging interface in a multi-slot charger according to exemplary embodiments of the present disclosure;
FIG. 20 is a schematic structural diagram of a charging interface in a multi-slot charger according to exemplary embodiments of the present disclosure;
FIG. 21 is a front view of a charging interface in a multi-slot charger according to exemplary embodiments of the present disclosure;
FIG. 22 is a schematic structural diagram of a battery pack according to exemplary embodiments of the present disclosure;
FIG. 23 is a schematic diagram of an exploded structure of a battery pack according to exemplary embodiments of the present disclosure;
FIG. 24 is a side view of a multi-slot charger and a battery pack after assembled according to exemplary embodiments of the present disclosure;
FIG. 25 is a second schematic structural diagram of a battery according to exemplary embodiments of the present disclosure;
FIG. 26 is a second schematic diagram of an exploded structure of a battery pack according to exemplary embodiments of the present disclosure;
FIG. 27 is a schematic structural diagram of a handle assembly in a multi-slot charger according to exemplary embodiments of the present disclosure;
FIG. 28 is a schematic assembly diagram of a handle and a multi-slot charger housing according to exemplary embodiments of the present disclosure;
FIG. 29 is a schematic assembly diagram of a handle and a multi-slot charger housing from another angle according to exemplary embodiments of the present disclosure;
FIG. 30 is a schematic assembly diagram of a handle and a reinforcing plate according to exemplary embodiments of the present disclosure;
FIG. 31 is a schematic structural diagram of a handle according to exemplary embodiments of the present disclosure;
FIG. 32 is a schematic structural diagram of a reinforcing plate according to exemplary embodiments of the present disclosure;
FIG. 33 is a schematic assembly diagram of an auxiliary handle according to exemplary embodiments of the present disclosure;
FIG. 34 is a top view of a multi-slot charger and battery packs after assembled according to exemplary embodiments of the present disclosure;
FIG. 35 is a schematic diagram of a multi-slot charger placed horizontally according to exemplary embodiments of the present disclosure;
FIG. 36 is a schematic assembly diagram of a wall-mounting bracket and a multi-slot charger according to exemplary embodiments of the present disclosure; and
FIG. 37 is a schematic structural diagram of a wall-mounting bracket according to exemplary embodiments of the present disclosure.

Label Description:
multi-slot charger 100; first case 11; fixing post 1101; through hole 1102; second case 12; handle assembly 20; lifting handle 21; main part 211; flat structure 212; connecting post 213; locking part 2131; through hole 2132; first auxiliary handle 22; second auxiliary handle 23; reinforcing plate 24; threaded hole 242; mounting hole 243; handle part 221; installation part 222; slope 2211; opening 2221; protruding structure 2222; recess 223; bottom edge 2201; side edge 2202; first supporting foot 224; second supporting foot 225; charging slot 101; circuit board assembly 102; power interface 103; switch 1031; first charging mode light 1041; second charging mode light 1042; charging slot indicator light 1043; cooling fan 106; first vent 107; second vent 108; slope structure 109; heat sink 110; first charging interface 111; groove 1111; power supply terminal 112; metal inlay 1113; socket assembly 113; connecting plate 1131; boss 1132; second charging interface 114; guide rail 1141; groove structure 1142 ; battery pack 30; upper case 31; handle 311; lower case 32; cell holder 33; circuit board 34; cell 35; cell connecting piece 36; terminal interface 37; cooperating interface 38; battery pack 40; upper case 41; lower case 42; cell holder 43; circuit board 44; terminal interface 47; cooperating interface 48; wall-mounting bracket 115; back panel 1151; location hole 11501; mounting hole 11502; ventilation slot 11503; bottom panel 1152; second bottom surface 11504.

### DESCRIPTION OF EMBODIMENTS

The following describes the embodiments of the present disclosure through specific examples. Those skilled in the art may easily understand other advantages and effects of the present disclosure from the content disclosed in this specification. The present disclosure may also be implemented or applied through other different specific embodiments. Various details in this specification may also be modified or changed in various ways based on different viewpoints and applications without departing from the present disclosure.

It should be noted that the diagrams provided in embodiments only illustrate the basic concept of the present disclosure in a schematic manner. The drawings may only show the components related to the present disclosure and may not be drawn according to the number, shape, and dimension of the components in the actual implementation. In actual implementation, the type, quantity, and scale of each component may be arbitrarily changed, and the component layout type may also be more complex.

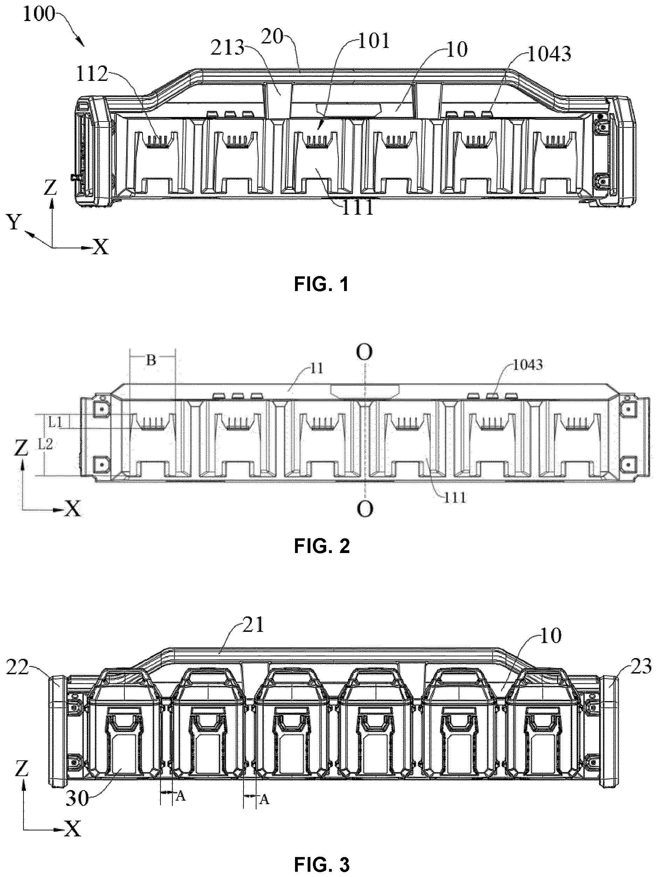

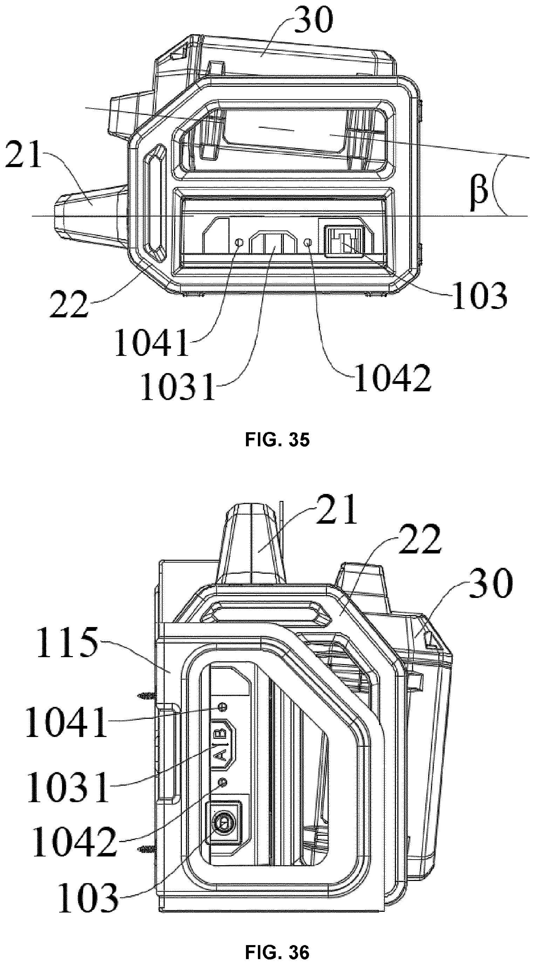

The present disclosure proposes a multi-slot charger 100. In some embodiments, the multi-slot charger may be used to solve the problem that the current charger may only charge one-to-one, which greatly affects the work efficiency when charging. In some embodiments, the multi-slot charger may be used to solve the problem that a large number of battery packs are charged separately, which may require large storage space, thereby bringing great trouble to production and processing. In some embodiments, the multi-slot charger may be used to solve the problem of poor heat dissipation effect. As shown in FIG. 1 and FIG. 36, a multi-slot charger 100 includes a charger housing and a handle assembly 20. The handle assembly 20 is installed on the charger housing 10. The charger housing is provided with a plurality of charging slots 101. The charging slots 101 are configured to accommodate battery packs 30. A plurality of circuit board assemblies 102 is installed in the charger housing. The circuit board assembly 102 is integrated with a charging circuit configured to charge the battery packs installed on the charging slots 101.

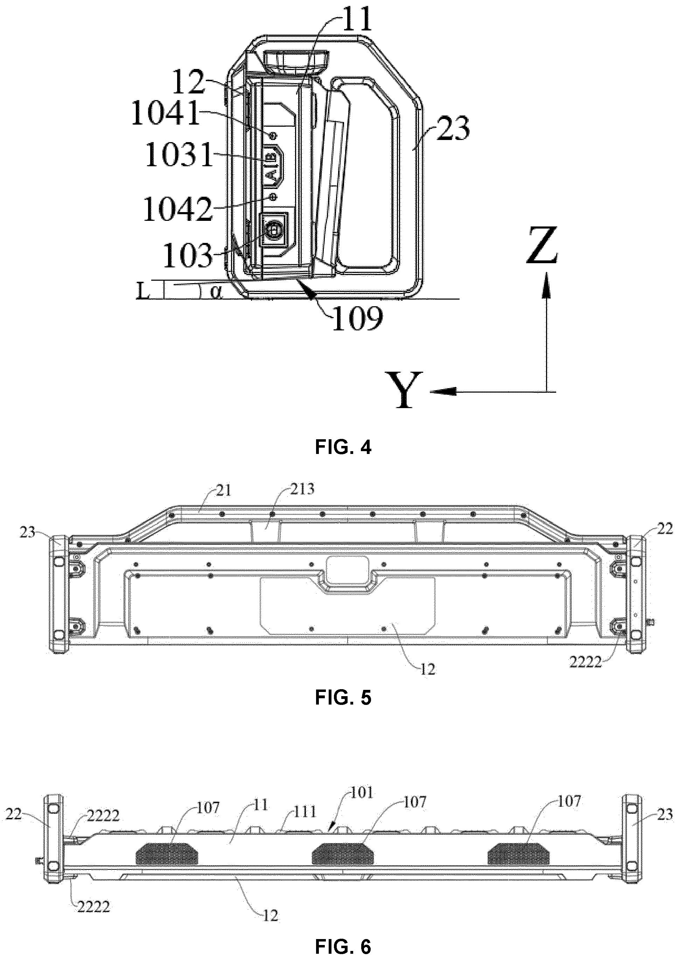

As shown in FIG. 1 to FIG. 6, in exemplary embodiments, the charger housing includes a first case 11 and a second case 12, and the first case 11 and the second case 12 are fixedly Installed together to form an accommodating chamber. In exemplary embodiments, the circuit board assembly 102 is installed in the accommodating chamber. In exemplary embodiments, a power interface 103 is provided on the side of the charger housing 10, the power interface 103 is electrically connected to a plurality of circuit board assemblies 102 in the accommodating chamber, and the power interface 103 is also configured to connect an external power source to provide charging power for the multi-slot charger 100. In exemplary embodiments, a switch 1031 is provided on the side of the charger housing 10 where the power interface 103 is provided, and the switch 1031 is located at the center line of the side of the charger housing 10. As shown in FIG. 1, the direction along X in FIG. 1 is the length direction of the multi-slot charger housing, the direction along Y in FIG. 1 is the width direction of the multi-slot charger housing, and the direction along Z in FIG. 1 is the height direction of the multi-slot charger housing. In exemplary embodiments, the ratio between the length, width, and height of the charger housing is, for example, set to (5~11):(1~2):(2~3). In exemplary embodiments, the length, width, and height of the charger housing are set to 1068 mm, 159 mm, and 264 mm, respectively.

As shown in FIG. 1 to FIG. 6, in addition, it should be noted that in exemplary embodiments, the multi-slot charger 100 is provided with at least two charging modes, that is, including a first charging mode where the charging starts from the battery pack 30 with the lowest power and a second charging mode where the charging starts from the battery pack 30 with the highest power. The switch 1031 is configured to control the switching of the charging mode of the multi-slot charger 100. In exemplary embodiments, the switch 1031 is configured to control switching between the first charging mode and the second charging mode. In exemplary embodiments, at least two charging indicator lights are provided on the side of the charger housing 10 where the power interface 103 is provided, and the charging indicator lights are located on both sides of the switch 1031, in order to observe whether the multi-slot charger 100 is connected to the power supply and is working. If the charging indicator light is on, it means that the power supply is connected and the multi-slot charger 100 is working. If the charging indicator light is off, it means that the power supply is not connected and the multi-slot charger 100 is non-working.

As shown in FIG. 1 to FIG. 6, in exemplary embodiments, the charging indicator light includes a first charging mode light 1041, and a second charging mode light 1042. When the first charging mode light 1041 is in an on state, and the second charging mode light 1042 is in an off state, it means that the multi-slot charger operates in the first charging mode. Press the switch 1031 again, and when the second charging mode light 1042 is in an on state and the first charging mode light 1041 is in an off state, it means that the multi-slot charger operates in the second charging mode.

As shown in FIG. 1 to FIG. 6, in exemplary embodiments, the charger housing 10 is provided with a plurality of charging slots 101, and the plurality of charging slots 101 is evenly distributed on the side of the charger housing 10 to accommodate multiple battery packs 30 so as to charge multiple battery packs 30 at the same time. It should be noted that in exemplary embodiments, the plurality of charging slots 101 is arranged at a certain spacing distance to prevent, when multiple battery packs 30 are installed on the multi-slot charger 100 at the same time and are to be charged at the same time, two adjacent battery packs 30 from interfering with each other and causing inconvenience or failure at installation. It should be noted that in exemplary embodiments, the spacing distance A between each two adjacent charging slots 101 is equal.

As shown in FIG. 1 and FIG. 3, In exemplary embodiments, the battery packs installed on the charging slot 101 are also arranged at the spacing distance A. In exemplary embodiments, the spacing distance A is the distance between adjacent sides of two adjacent battery packs. For example, the spacing distance A is between 3 mm and 100 mm, which is set as a safe distance during the charging process of the battery packs to prevent two adjacent battery packs from being too close to each other, which may cause collisions and scratches during insertion or removal. In addition, if the distance between two adjacent battery packs is too far, it may be inconvenient to operate. In exemplary embodiments, the number of the charging slots 101 is 1, 2, 3, 4, or more. In exemplary embodiments, the number of the charging slots 101 is 6, and these 6 charging slots 101 are symmetrically arranged on the side of the first case 11 away from the second case 12 to charge multiple battery packs 30 at the same time.

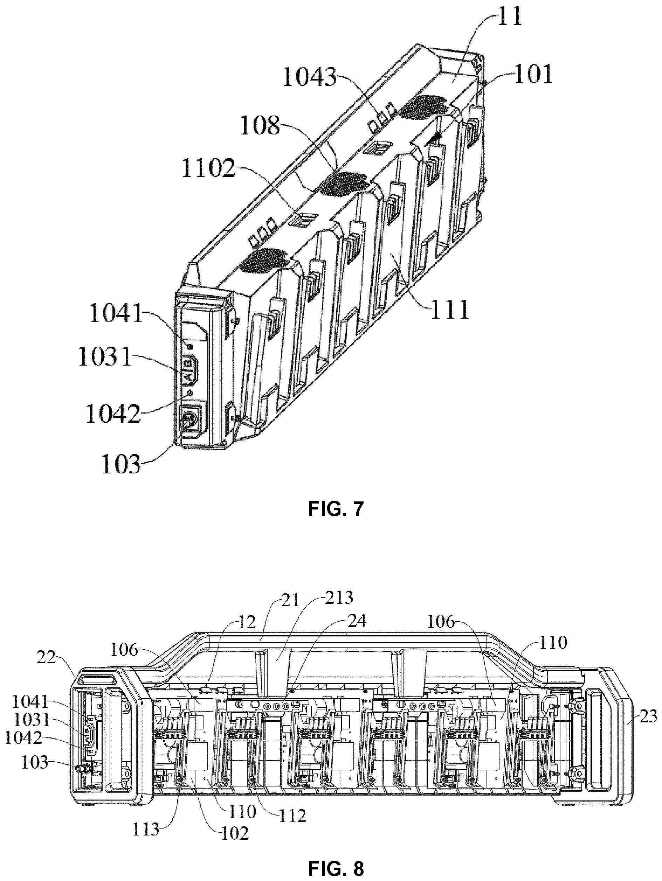

As shown in FIG. 1 and FIG. 7, in exemplary embodiments, the multi-slot charger 100 further includes a plurality of charging slot indicator lights 1043. In exemplary embodiments, the plurality of the charging slot indicator lights 1043 is disposed on the top of the first case 11 and is located below a lifting handle 21 of a handle assembly 20, and the number of the charging slot indicator lights 1043 corresponds to the number of charging slots 101 on the multi-slot charger 100 in a one-to-one manner. In exemplary embodiments, the number of the charging slot indicator lights 1043 is 6, and the charging slot indicator lights 1043 are divided into two groups, and the two groups of charging slot indicator lights 1043 are symmetrically arranged on left and right sides relative to the middle line O-O of the entire multi-slot charger 100 and are located at the top of the second and fourth charging slots 101, respectively. When a battery pack 30 is inserted into a certain charging slot 101 and is charged normally, the charging slot indicator light 1043 corresponds to this charging slot 101 lights up. In exemplary embodiments, the plurality of charging slot indicator lights 1043 is located above the corresponding charging slot 101 respectively or at other locations.

As shown in FIG. 1, In exemplary embodiments, since the second case 12 is long, thin, and easily deformed or damaged, horizontal-and-vertical-grid shaped reinforcing ribs are provided on the inner wall of the second case 12, to reinforce the second case 12 to prevent it from being deformed or damaged.

As shown in FIG. 1, FIG. 8, and FIG. 9, in exemplary embodiments, a plurality of circuit board assemblies 102 is provided in the charger housing 10. In exemplary embodiments, each charging slot 101 is equipped with a set of power supply terminals 112, and the set of power supply terminals 112 and the charging circuit on the circuit board assembly 102 form a charging loop to charge a battery pack 30. In exemplary embodiments, every two charging slots 101 share a circuit board assembly 102, that is, each circuit board assembly 102 forms two charging loops with the power supply terminals 112 on two charging slots 101 at the same time, so as to simultaneously charge the two battery packs 30 in a situation where the two charging loops do not interfere with each other. In exemplary embodiments, a cooling fan 106 is also installed on each circuit board assembly 102, and a second vent is provided on the charger housing 10. The second vent corresponds to the cooling fan 106 one-to-one to achieve the heat dissipation function on the circuit board assembly 102 and improve the heat dissipation effect of the multi-slot charger so as to extend the lifespan of the multi-slot charger. In some embodiments, the number of the circuit board assembly is one, and this circuit board assembly is arranged along the vertical direction, that is, each set of power supply terminals 112 on the multi-slot charger shares one circuit board.

As shown in FIG. 1, FIG. 11, and FIG. 12, in exemplary embodiments, the charger housing 10 is provided with a plurality of first vents 107 and a plurality of second vents 108, and the number of the first vents 107 and the number of the second vents 108 respectively corresponds to the number of the circuit board assemblies 102, that is, to the number of the cooling fans 106 in a one-to-one manner. In exemplary embodiments, the first vents 107 are provided at the bottom of the first case 11, and the second vents 108 are provided at the top of the first case 11. In exemplary embodiments, the cooling fans 106 are installed on the circuit board assemblies 102, directly facing the second vents 108, and located close to the top of the first case 11. In some embodiments, the number of the first vents 107 is more than the number of the second vents 108.

As shown in FIG. 1, FIG. 11, and FIG. 12, In exemplary embodiments, the first vents 107 and the second vents 108 are in a honeycomb shape. In some embodiments, the first vents 107 and the second vents 108 are configured in other shapes, and the area ratio of the first vent 107 to the second vent 108 is, for example, between 1 and 2. Under this area ratio, sufficient airflow may be ensured to pass through the high-temperature components on the circuit board, to improve its ventilation effect and thereby enhance its heat dissipation effect.

As shown in FIG. 1, FIG. 4, FIG. 11, and FIG. 12, in exemplary embodiments, the bottom surface of the charger housing 10 is inclined, that is, the bottom surface is a slope structure 109. In exemplary embodiments, the direction of the slope structure 109 is obliquely downward relative to the direction from the first case 11 to the second case 12, and the angle α between the slope structure 109 and the ground is in the range of 3° to 6°. There is a spacing distance L between the lowest point of the slope structure 109 and the ground, and the range of the spacing distance L is, for example, between 5 mm and 20 mm. In exemplary embodiments, the angle α between the slope structure 109 and the ground is 3°, and the spacing distance L is 16 mm, so that the first vent 107 on the bottom surface of the charger housing 10 is always kept at a certain distance and angle from the bottom surface to avoid the first vent 107 from being blocked, so that the ventilation inside the multi-slot charger 100 is affected, thereby affecting the heat dissipation effect of the multi-slot charger 100. Therefore, sufficient air volume may enter the multi-slot charger 100, to realize the heat dissipation of internal high-temperature components of the multi-slot charger 100. With the existence of this angle α, the first case 11 of the multi-slot charger 100 is easier to de-mold during the injection molding process.

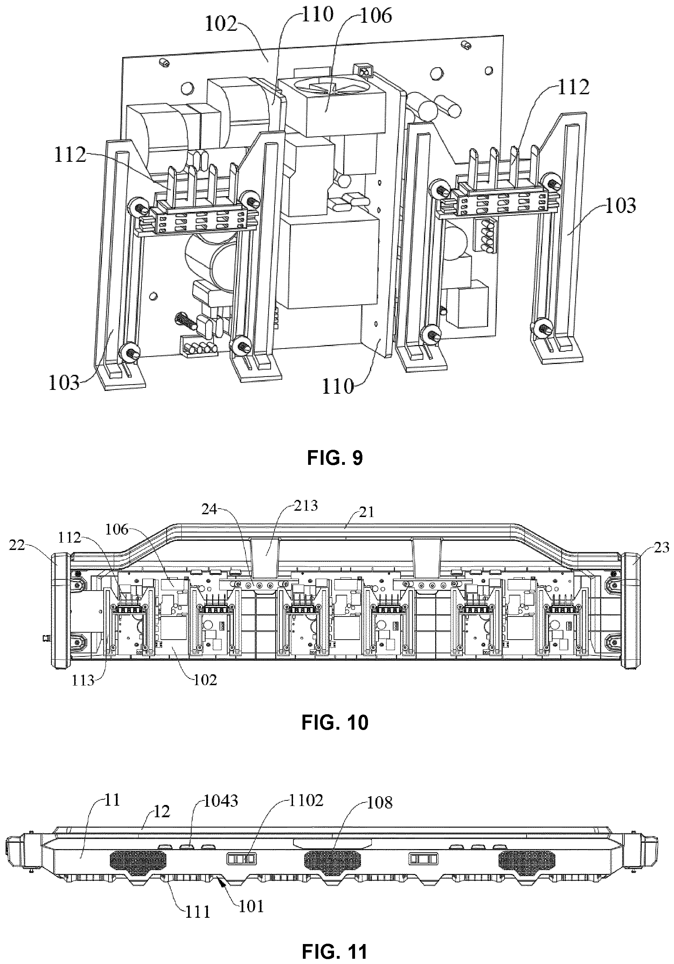

As shown in FIG. 8 and FIG. 9, in some embodiments, the multi-slot charger 100 also includes multiple groups of heat sinks, and the multiple groups of heat sinks are installed on the circuit board assemblies 102. In exemplary embodiments, each of the heat sinks is arranged on the circuit board assembly 102 along the vertical direction, and an air duct body is formed between the heat sinks 110 to enhance its heat dissipation effect. In some embodiments, the flow direction of the airflow is parallel to the heat sinks 100 to further enhance the heat dissipation effect.

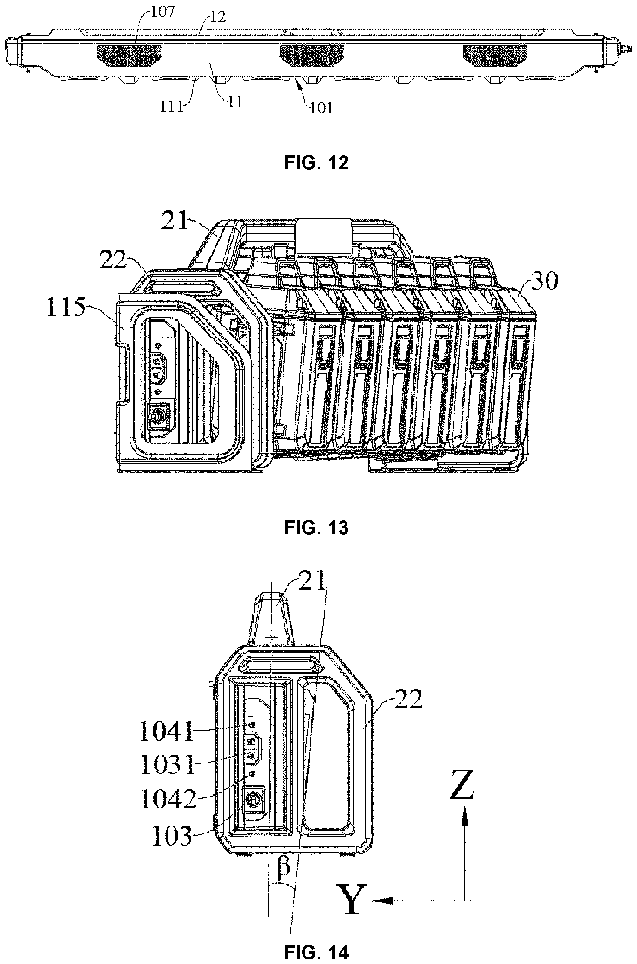

As shown in FIG. 1 and FIG. 14, in exemplary embodiments, the multi-slot charger 100 may be placed in different ways. For example, the multi-slot charger 100 may be placed vertically, horizontally, or in a hanging way. Regardless of the way that the multi-slot charger 100 is placed (vertical, horizontal, or wall-mounted), the battery pack 30 may be conveniently inserted into the first charging interface 111 of the multi-slot charger 100, making it easy to operate. Therefore, there is an angle between the first charging interface 111 and the vertical line of the multi-slot charger 100 to facilitate the insertion or removal of the battery pack 30 from the first charging interface 111 of the multi-slot charger 100.

As shown in FIG. 1 and FIG. 14, the multi-slot charger 100 placed vertically is taken as an example for explanation. In exemplary embodiments, the charging slot 101 is provided with a first charging interface 111. When the multi-slot charger 100 is placed vertically, the first charging interface 111 is arranged obliquely in the charging slot 101. The first charging interface 111 is arranged in the charging slot 101 in a direction from the top of the multi-slot charger 100 pointing obliquely downward toward the bottom of the multi-slot charger 100, that is, the top of the first charging interface 111 is away from the second case 12, and the bottom of the first charging interface 111 is close to the second case 12. In exemplary embodiments, there is an angle β between the first charging interface 111 and the vertical direction of the multi-slot charger 100, and the range of the angle β is 0° to 60°. In exemplary embodiments, the range of the included angle β is 0° to 45°. In exemplary embodiments, the range of the included angle β is 0° to 30°. In exemplary embodiments, the range of the included angle β is 0° to 15°. In exemplary embodiments, the range of the included angle β is 0° to 10°. This may facilitate the cooperative installation of the battery pack 30 and the first charging interface 111 for charging.

As shown in FIG. 1 and FIG. 2, in exemplary embodiments, a charging guide rail is provided on the first charging interface 111 for cooperative installation of the battery pack 30, and the width B of the charging guide rail is 30 mm to 90 mm. In addition, the total length L2 of the first charging interface 111 is set in a range of 100 mm to 110 mm to match a cooperating interface on the battery pack 30 so that it can be firmly mated and charged.

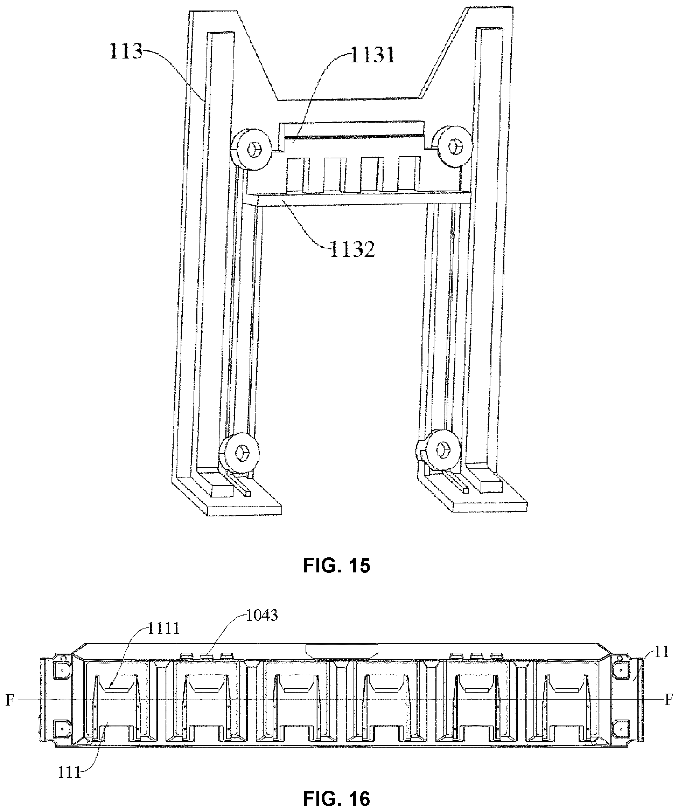

As shown in FIG. 1, FIG. 10, and FIG. 16, In exemplary embodiments, the inside of the first charging interface 111 has a cavity, and its top is recessed downward to form a groove 1111. The depth L1 of the groove 1111 ranges from 20 mm to 30 mm. A power supply terminal 112 is installed at the bottom of the groove 1111, and the power supply terminal 112 is configured to connect with the terminal of the battery pack 30. In exemplary embodiments, a socket assembly 113 is provided inside the multi-slot charger 100. The socket assembly 113 is fixedly connected to the inner wall of the first case 11 and corresponds to the charging slot 101 in a one-to-one way. The surfaces of the two sides of the socket assembly 113 are flush with the bottom surface of the charging slot 101. The socket assembly 113 includes a connecting plate 1131, and the connecting plate 1131 is located in a position of the socket assembly 113 near the top. The bottom of the connecting plate 1131 extends outward to form a boss 1132 for supporting the power supply terminal 112. A plurality of through holes is provided at intervals on the connecting plate 1131. The power supply terminal 112 is connected to the socket assembly 113 so that the internal circuit of the multi-slot charger 100 is connected to the power supply terminal 112.

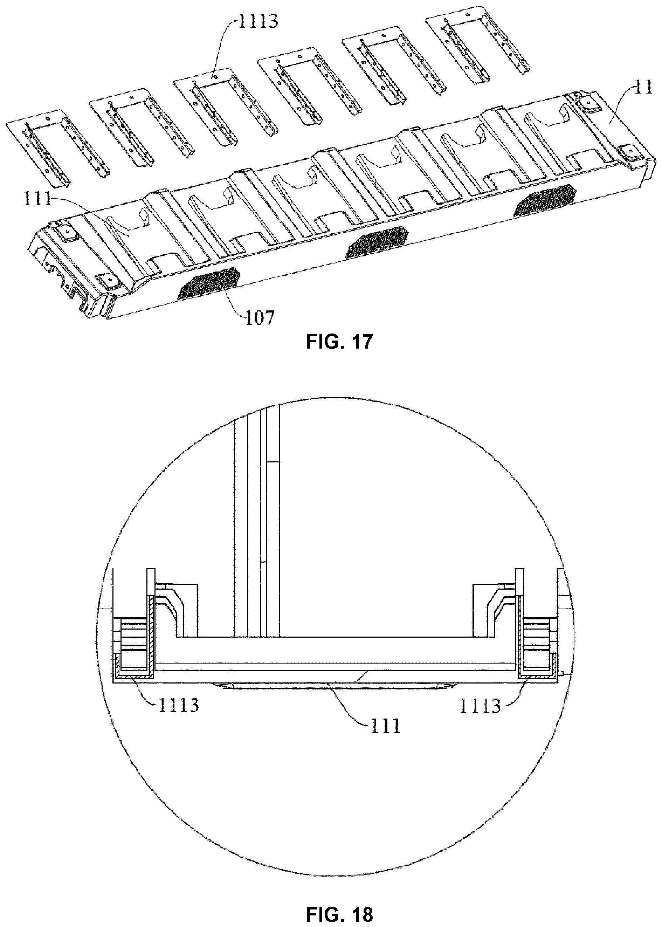

As shown in FIG. 13, FIG. 16 and FIG. 18, in addition, it should be noted that in exemplary embodiments, the first charging interface 111 includes a charging interface to facilitate the cooperative installation of the charging interface 111 and the battery pack. The charging interface 111 is embedded with a metal inlay 1113 to enhance its structural strength and extend its service life. In exemplary embodiments, when the battery pack 30 is inserted along the first charging interface 111, the first charging interface 111 will be subject to a certain friction force, and during use, the first charging interface 111 will also be subject to pressure exerted by the battery pack 30. Therefore, the metal inlay 1113 is embedded in the first charging interface 111 to enhance the structural strength of the first charging interface 111. In some embodiments, the structural strength of the first charging interface 111 may also be strengthened by increasing its wall thickness or adding reinforcing ribs.

As shown in FIG. 14, FIG. 16 and FIG. 18, in exemplary embodiments, when one or more battery packs are installed on the multi-slot charger 100, the ratio P of the total weight of the battery packs and the weight of the multi-slot charger 100 is between 1/10 and 4. In exemplary embodiments, the charging power range of the multi-slot charger is, for example, between 200 W and 2000 W to meet charging needs in different situations.

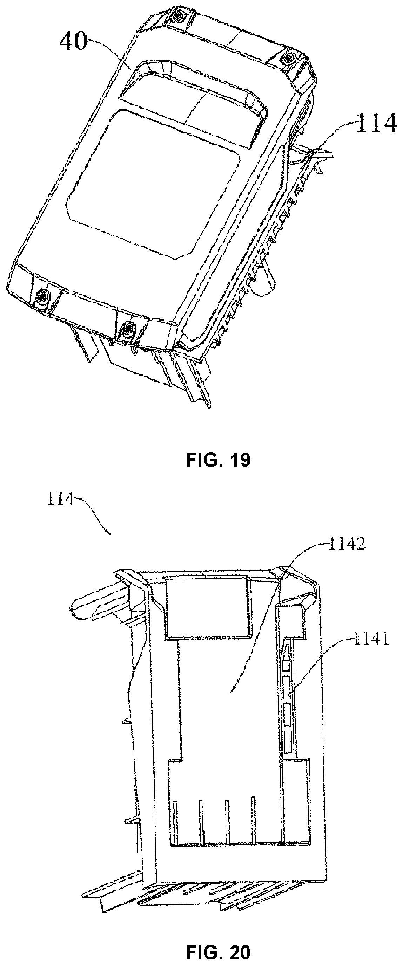

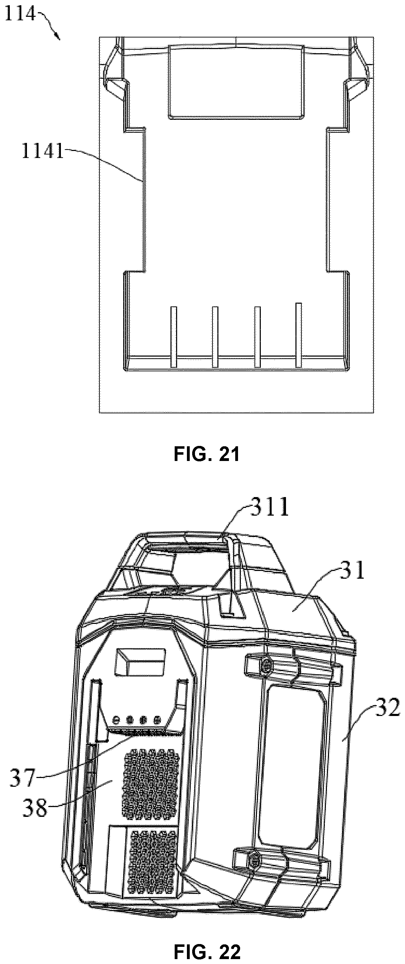

As shown in FIG. 19 to FIG. 21, exemplary embodiments of the present disclosure provide a second charging interface 114 to replace the first charging interface 111. Similarly, when the multi-slot charger 100 is placed vertically, the second charging interface 114 is arranged obliquely in the charging slot 101.The second charging interface 114 is arranged in the charging slot 101 in a direction from the top of the multi-slot charger 100 pointing obliquely downward toward the bottom of the multi-slot charger 100, that is, the top of the second charging interface 114 is away from the second case 12, and the bottom of the second charging interface 114 is close to the second case 12. In exemplary embodiments, there is an angle β between the second charging interface 114 and the vertical direction of the multi-slot charger 100. The range of the angle β is between 0° and 60°. In exemplary embodiments, the range of the angle β is between 0° and 45°. In exemplary embodiments, the range of the angle β is between 0° and 30°. In exemplary embodiments, the angle β is between 0° and 15°. in exemplary embodiments, the angle β is between 0° and 10°. This may facilitate the cooperative installation of the battery pack 30 and the second charging interface 114 for charging.

As shown in FIG. 19 to FIG. 21, in exemplary embodiments, the second charging interface 114 has a groove structure 1142, and guide rails 1141 are provided on two opposite inner side walls of the groove structure 1142 to cooperate with the installation of another type of battery pack 40. Similarly, in exemplary embodiments, the power supply terminal 112 is installed at the bottom of the second charging interface 114 and is configured to connect to the terminal interface of the battery pack 40 to charge the battery pack 40.

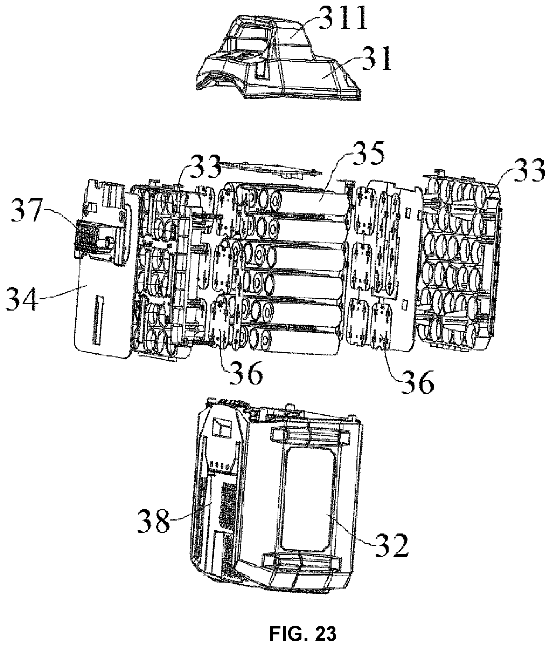

As shown in FIG. 1, FIG. 13, FIG. 22, and FIG. 23, in exemplary embodiments, when the multi-slot charger 100 is configured with the first charging interface 111, the battery pack 30 that cooperates with the first charging interface 111 is barrel-shaped. Correspondingly, there is an included angle β between the axis of the battery pack 30 and the vertical direction of the multi-slot charger 100, and the range of the included angle β is between 0° and 60°. In exemplary embodiments, the range of the included angle β is 0° to 45°. In exemplary embodiments, the range of the included angle β is 0° to 30°. In exemplary embodiments, the range of the included angle β is between 0° to 15°. In exemplary embodiments, the included angle β is between 0° and 10°. This may facilitate the cooperative installation of the battery pack 30 and the second charging interface 114 for charging. In exemplary embodiments, the battery pack 30 includes an upper case 31, a lower case 32, a cell holder 33, and a circuit board 34. The upper case 31 and the lower case 32 are connected to form an accommodating chamber. The cell holder 33 and the circuit board 34 are located in the accommodating chamber. A plurality of cells 35 is installed in the cell holder 33, and the plurality of cells 35 is electrically connected together through cell connecting pieces 36. The circuit board 34 and the cells 35 are electrically connected. In addition, the battery pack 30 also includes a terminal interface 37, and the terminal interface 37 and the circuit board 34 are electrically connected.

As shown in FIG. 1, FIG. 13, FIG. 19 and FIG. 23, in exemplary embodiments, a cooperating interface 38 cooperating with the first charging interface 111 is provided on one side of the lower case 32. A terminal interface 37 is located at the top of the cooperating interface 38, and the power supply terminal 112 is connected to the terminal interface 37 on the top of the cooperating interface 38 to charge the battery pack 30. In exemplary embodiments, the upper case 31 is also provided with a handle 311 to facilitate the user to take or move the battery pack 30. It should also be noted that when the battery pack 30 is installed on the multi-slot charger 100 for charging, the axis direction of the cell 35 in the battery pack 30 and the direction of the first charging interface 111 are mutually parallel or perpendicular. In exemplary embodiments, the axis direction of the cell 35 in the battery pack 30 and the direction of the first charging interface 111 are set to be perpendicular to each other.

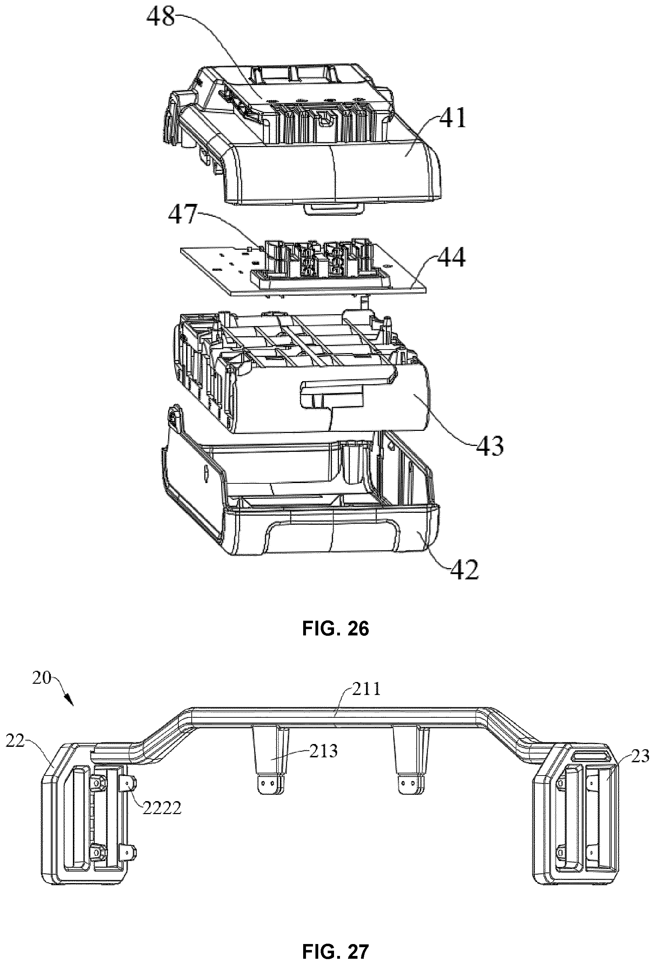

As shown in FIG. 1, FIG. 19, FIG. 25 and FIG. 26, in exemplary embodiments, when the multi-slot charger 100 is configured with the second charging interface 114, the battery pack 40 is a single-voltage battery. The battery pack 40 includes an upper case 41, a lower case 42, a cell holder 43, and a circuit board 44. It is estimated that the upper case 41 and the lower case 42 are connected to form an accommodating chamber. The cell holder 43 and the circuit board 44 are located in the accommodating chamber. A plurality of cells (not shown) is installed in the cell holder 43, and the plurality of cells is electrically connected together through cell connecting pieces (not shown). The circuit board 44 is electrically connected to the cells. In addition, the battery pack 40 also includes a terminal interface 47, and the terminal interface 47 is electrically connected to the circuit board 44.

As shown in FIG. 1, FIG. 19, FIG. 25 and FIG. 26, in exemplary embodiments, the upper case 41 is provided with a cooperating interface 48 that cooperates with the second charging interface 114. A terminal interface 47 is located at the cooperating interface 48. When the battery pack 40 is cooperatively installed to the second charging interface 114, the power supply terminal 112 is connected to the terminal interface 47 on the cooperating interface 48 to charge the battery pack 40. Similarly, it should be noted that when the battery pack 40 is installed on the multi-slot charger 100 for charging, the axis direction of the cells in the battery pack 40 and the direction of the second charging interface 114 are parallel or perpendicular to each other.

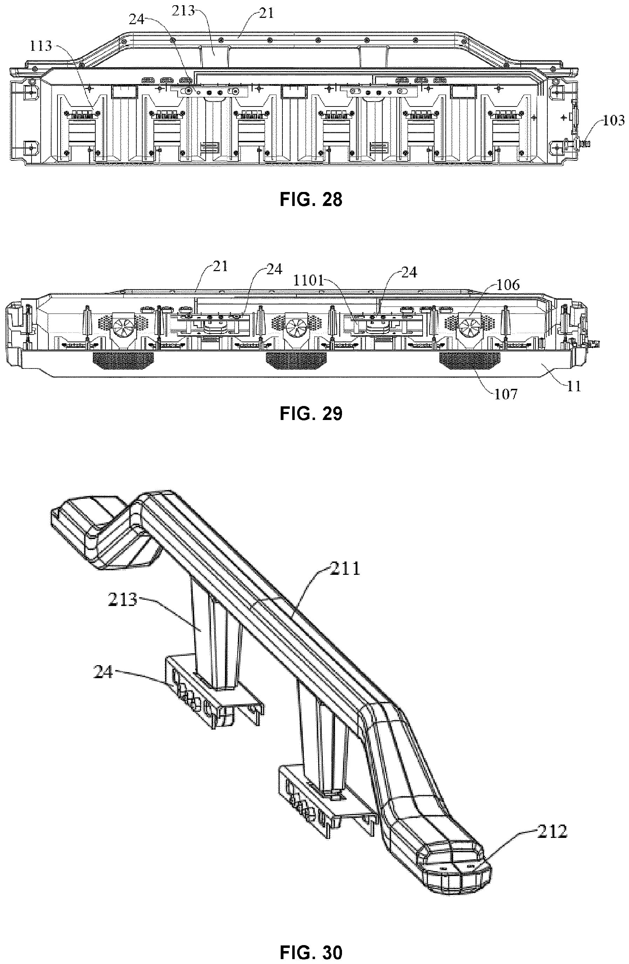

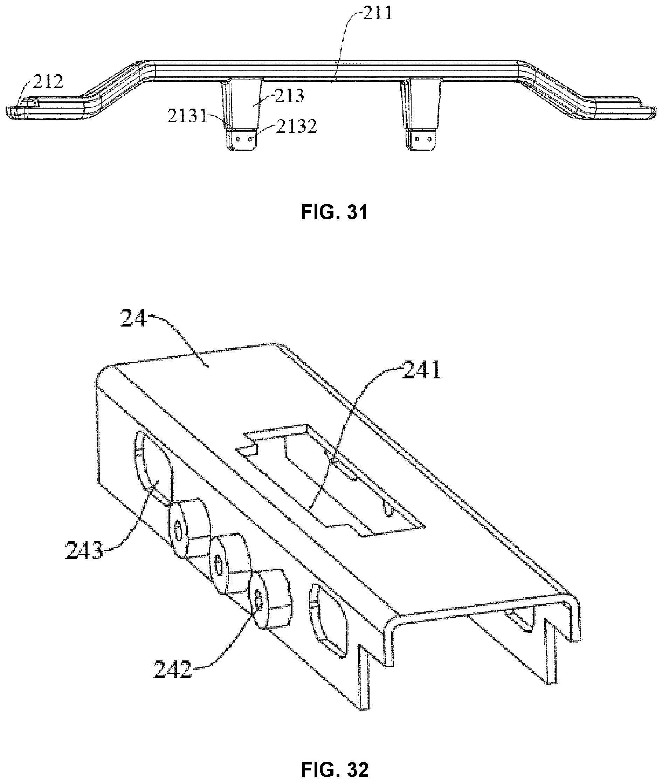

As shown in FIG. 1 and FIG. 27 to FIG. 33, in exemplary embodiments, the multi-slot charger 100 further includes a handle assembly, and the handle assembly includes a lifting handle 21, a first auxiliary handle 22, and a second auxiliary handle 23. In exemplary embodiments, the lifting handle 21 is located on the top of the multi-slot charger 100 and is provided on the top of the housing 10 along the length direction (X direction) of the housing 10. The first auxiliary handle 22 and the second auxiliary handle 23 are respectively installed on two sides of the multi-slot charger 100 along the length direction (X direction) and are fixedly connected with the first case 11 and the second case 12. In some embodiments, two ends of the lifting handle 21 are also fixedly connected to the first auxiliary handle 22 and the second auxiliary handle 23, respectively. In exemplary embodiments, the lifting handle 21 has an arcuate structure, the middle main part 211 is similar to a cylinder, and two ends thereof are configured as flat structures 212 to facilitate the fixed connection with the first auxiliary handle 22 and the second auxiliary handle 22. In exemplary embodiments, the main part 211 of the lifting handle 21 extends downward to form two connecting posts 213. The connecting posts 213 extend into the interior of the multi-slot charger 100 through the through hole 1102 of the first case 11 and are fixedly connected to the multi-slot charger 100 through the reinforcing plate 24.

As shown in FIGS. 1 and 27 to 33, it should be noted that in exemplary embodiments, since the multi-slot charger 100 has a "slender structure", the area where the first auxiliary handle 22 and the second auxiliary handles 22 are connected to the multi-slot charger 100 surrounds and fixes the end surfaces of the first case 11 and the second case 12 of the multi-slot charger 100, and is then connected and fixed to the lifting handle 21. This structure increases the force-bearing area and is more reliable overall. If the first auxiliary handle 22 and the second auxiliary handle 22 are removed, the lifting handle 21 is directly fixed to the first case 11 and/or the second case 12 of the multi-slot charger 100 by screws. The force is concentrated at the screw fixing point, the force-bearing area is too small, and the housing is easily damaged.

As shown in FIG. 1 and FIG. 27 to FIG. 33, in exemplary embodiments, a locking part 2131 and a plurality of through holes 2132 is provided near the bottom of the connecting post 213. The plurality of through holes 2132 is located at the lower part of the locking part 2131. The reinforcing plate 24 is also provided with a locking structure 241 cooperating with the locking part 2131 and a threaded hole 242 cooperating with the through hole 2132, that is, the reinforcing plate 24 is cooperatively installed to the locking part 2131 through the locking structure 241, and then bolts are passed through the through holes 2132 and the threaded holes 242 to firmly connect the connecting post 213 and the reinforcing plate 24 together. In exemplary embodiments, the reinforcing plate 24 is also provided with mounting holes 243 at both ends, and the inner wall of the first case 11 is provided with a fixing post 1101 that cooperates with the mounting holes 243, that is, the fixing posts 1101 pass through the mounting holes 243 and are fixed by bolts to connect the reinforcing plate 24 and the multi-slot charger 100 together.

As shown in FIGS. 1 and 27 to 33, In exemplary embodiments, the first auxiliary handle 22 and the second auxiliary handle 23 are symmetrically installed on both sides of the multi-slot charger 100, and are fixedly connected to the first case 11, the second case 12, and the lifting handle 21, and the first auxiliary handle 22 and the second auxiliary handle 23 have the same structure.

As shown in FIGS. 1 and 27 to 33, in exemplary embodiments, the first auxiliary handle 22 is taken as an example for explanation. The first auxiliary handle 22 includes a handle part 221 and an installation part 222. In exemplary embodiments, the installation part 222 includes an opening 2221, and the opening 2221 can accommodate the first case 11 and the second case 12. That is, after the first case 11 and the second case 12 are fixedly installed together, one ends of the first case 11 and the second case 12 are located in the opening 2221. In exemplary embodiments, the installation part 222 is also provided with a plurality of protruding structures 2222, and the plurality of protruding structures 2222 is respectively located at two sides of the opening 2221 and are symmetrically distributed. In exemplary embodiments, the protruding structures 2222 are arranged along the height direction of the multi-slot charger 100 for connecting the first case 11 and the second case 12 through bolts. In exemplary embodiments, the number of the protruding structures 2222 is 4. For example, each side of the opening 2221 is provided with two protruding structures 2222 to fixedly connect with the first case 11 and the second case 12 through bolts, respectively. In exemplary embodiments, the top of the first auxiliary handle 22 is provided with a recess 223, and the recess 223 is located above the opening 2221 and is configured to be fixedly connected to the flat structures 212 at two ends of the lifting handle 21. In exemplary embodiments, the flat structures 212 at two ends of the lifting handle 21 are located in the recess 223 and are fixedly connected thereto by bolts. In exemplary embodiments, the handle part 221 is fixedly connected to the installation part 222. In exemplary embodiments, the handle part 221 is integrated with the installation part 222. In exemplary embodiments, the handle part 221 is located on one side of the installation part 222 to facilitate users to take or move the multi-slot charger 100. In exemplary embodiments, the top of the handle part 221 away from the installation part 222 is provided with a slope 2211. For example, the angle between the slope 2211 and the vertical direction is 45°, to facilitate operation by the operator.

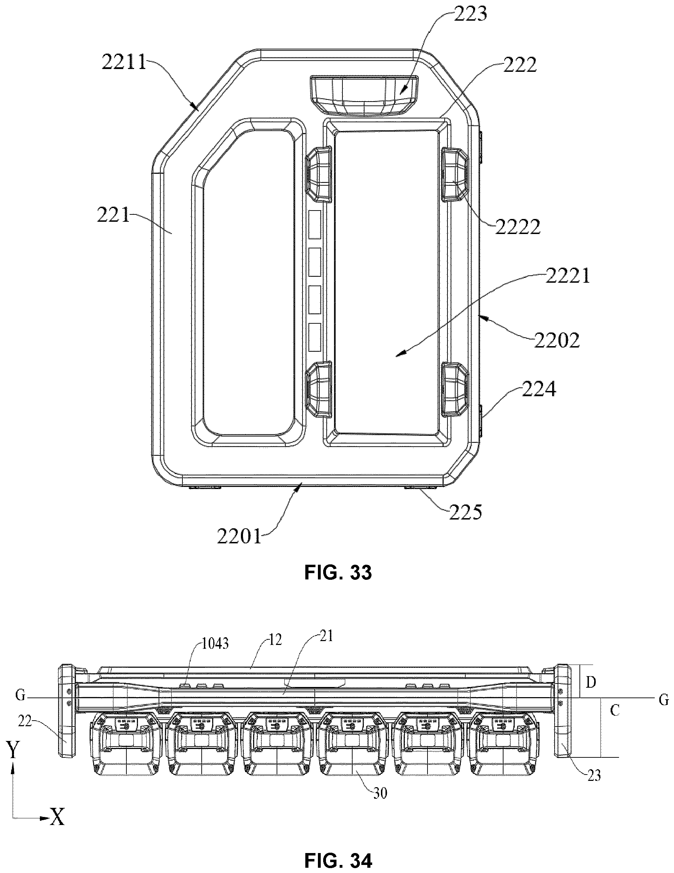

As shown in FIG. 1 and FIG. 34, it should be noted that since the weight of the side of the multi-slot charger 100 on which the battery pack is installed is heavier, the center of gravity of the multi-slot charger 100 is likely to deviate, and the entire multi-slot charger 100 is likely to lose balance and tilt to one side. Therefore, in exemplary embodiments, the handle assembly 20 is arranged on the top of the housing along the length direction (X direction), and the spacing ratio of the vertical distances between two sides of the auxiliary handle and the center line G-G of the lifting handle 21 in the handle assembly 20 in the width direction (Y direction) of the housing 10 is between 1 and 3. In exemplary embodiments, the ratio of the vertical distance between the front side of the auxiliary handle and the center line of the lifting handle 21 to the vertical distance between the rear side of the auxiliary handle and the center line of the lifting handle 21 is between 1 and 3. In exemplary embodiments, the front side of the auxiliary handle is the side of the housing 10 where the charging slot is provided, and the rear side of the auxiliary handle is the side of the housing 10 where the second case 12 is located. In exemplary embodiments, the vertical distance between the center line of the lifting handle 21 and the side of the auxiliary handle close to the charging slot 101 is C, the vertical distance between the axis of the lifting handle 21 and the side of the auxiliary handle close to the second case 12 is D, and the ratio the vertical distance C to the vertical distance D ranges from 1 to 3 to ensure the overall stability of the multi-slot charger 100, thereby ensuring the smoothness of the charging process.

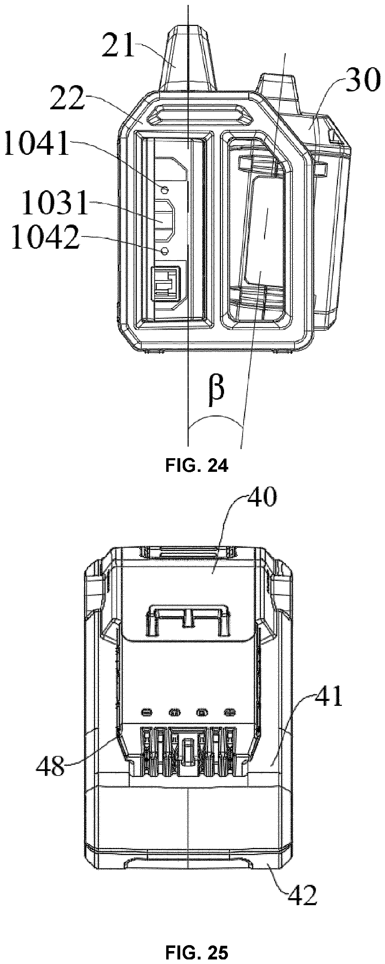

As shown in FIG. 1, FIG. 24, and FIG. 35 to FIG. 37, in exemplary embodiments, the multi-slot charger 100 is placed in a variety of ways. For example, the multi-slot charger 100 is placed in a vertical way as shown in FIG. 24. For example, the multi-slot charger 100 is placed in a horizontal way as shown in FIG. 35. For example, the multi-slot charger 100 is placed in a wall-mounted way as shown in FIG. 36. When the multi-slot charger is placed vertically, the bottom surface of the auxiliary handle contacts the ground to support the multi-slot charger. For example, the bottom edge 2201 of the auxiliary handle contacts the ground for support. When the multi-slot charger is placed horizontally, the side edge 2202 of the auxiliary handle contacts the ground for support. In some embodiments, a first supporting foot 224 is provided on the side of the installation part 222 away from the handle part 221, and a second supporting foot 225 is also provided on the bottom surface of the first auxiliary handle 22. The supporting feet at these two positions play a supporting role when the multi-slot charger 100 is placed in different ways. In exemplary embodiments, when the multi-slot charger 100 is placed vertically, the second supporting foot 225 on the bottom of the first auxiliary handle 22 plays a supporting role, and the user can move the multi-slot charger 100 by using the lifting handle 21. When the multi-slot charger 100 is placed horizontally, the first supporting foot 224 on the side of the installation part 222 away from the handle part 221 plays a supporting role, and the user can move the multi-slot charger 100 by using the handle part 221. When the multi-slot charger 100 is wall-mounted, the multi-slot charger 100 can be hung on a vertical surface through a wall-mounting bracket 115.

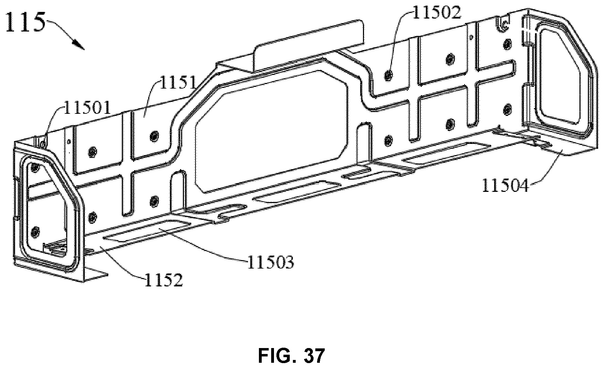

As shown in FIGS. 36 and 37, in exemplary embodiments, the wall-mounting bracket 115 is fixedly installed on the multi-slot charger 100, and the wall-mounting bracket 115 surrounds and covers the multi-slot charger 100 from all sides. In exemplary embodiments, the wall-mounting bracket 115 includes a back panel 1151 for covering the second case 12 on the multi-slot charger 100, and location holes 11501 are respectively provided at positions near the top of two sides of the back panel 1151. In exemplary embodiments, two location holes 11501 are located on the same straight line. The location holes 11501 are configured to fix and limit the multi-slot charger 100 to ensure that the multi-slot charger 100 is accurately positioned on the wall-mounting bracket 115 to facilitate installation. In exemplary embodiments, due to the large length and thin thickness of the back panel 1151, to ensure its strength, a plurality of reinforcing ribs is formed on the back panel 1151 to increase its strength. In exemplary embodiments, the reinforcing ribs are integrally formed with the back panel 1151.

As shown in FIG. 36 and FIG. 37, in exemplary embodiments, there is a plurality of mounting holes 11502 on the back panel 1151. For example, the wall-mounting bracket 115 is fixed on the vertical surface through the mounting holes 11502. In exemplary embodiments, a plurality of mounting holes 11502 is evenly distributed on the back panel 1151 to ensure the uniformity of force applied on the wall-mounting bracket 115 during the hanging process, thereby ensuring its stability of hanging.

As shown in FIG. 36 and FIG. 37, in exemplary embodiments, the wall-mounting bracket 115 also includes a bottom panel 1152 for supporting and covering the bottom surface of the multi-slot charger 100. The bottom panel 1152 fits with the bottom surface of the multi-slot charger 100 to better support the multi-slot charger 100. Since there is an angle ranging from 3° to 6° between the bottom surface of the multi-slot charger 100 and the horizontal plane, correspondingly, an included angle ranging from 94° to 97° exists between the bottom panel 1152 and the back panel 1151 to better fit the bottom surface of the multi-slot charger 100.

As shown in FIG. 36 and FIG. 37, in exemplary embodiments, a plurality of ventilation slots 11503 is provided on the bottom panel 1152 at intervals, and the plurality of ventilation slots 11503 respectively corresponds to the first vents 107 at the bottom of the multi-slot charger 100 in a one-to-one way, so that the ventilation inside the multi-slot charger 100 is not affected, thereby avoiding affecting its heat dissipation effect.

As shown in FIG. 36 and FIG. 37, in exemplary embodiments, the wall-mounting bracket 115 also includes a first side panel and a second side panel. The first side panel and the second side panel are configured to cover the first auxiliary handle 22 and the second auxiliary handle 23 of the multi-slot charger 100, respectively. Second bottom surfaces 11504 are formed on and extended from the first side panel and the second side panel in the direction facing inward, i.e., facing toward the back panel 1151. The second bottom surface 11504 and the back panel 1151 are perpendicular to each other. The second bottom surfaces 11504 are configured to support the first auxiliary handle 22 and the second auxiliary handle 23. In exemplary embodiments, the bottom panel 1152 and the second bottom surfaces 11504 are both rigid force-bearing surfaces to better support the multi-slot charger 100. In exemplary embodiments, the weight of the battery pack 30 is passed to the multi-slot charger 100 through the first charging interface 111, and the weight of the multi-slot charger 100 is passed to the wall-mounting bracket 115 through the first case 11, the second case 12, the first auxiliary handle 22, and the second auxiliary handle 23. The multi-slot charger 100 is fixed on the vertical surface through the mounting hole 11502 on the wall-mounting bracket 115 with screws.

As shown in FIG. 35 and FIG. 37, in exemplary embodiments, the back panel 1151, the bottom panel 1152, the first side panel, the second side panel, and the second bottom surfaces 11504 are integrally formed to further enhance the strength of the wall-mounting bracket 115. In exemplary embodiments, the wall-mounting bracket 115 is, for example, a sheet metal part. In exemplary embodiments, the wall-mounting bracket 115 is made of aluminum and its alloys, as long as its structural strength is met. In exemplary embodiments, the ratio of the weight of the wall-mounted bracket 115 to the weight of the multi-slot charger 100 with the battery packs installed ranges from 0.1 to 0.5, making it easier to move and install. It should also be noted that to facilitate movement and installation, the wall-mounting bracket 115 is lighter in weight as long as its structural strength is met.

As shown in FIG. 35 and FIG. 37, in exemplary embodiments, the installation process includes: first passing bolts through the mounting holes 11502 on the back panel 1151 to fix the wall-mounting bracket 115 to a vertical surface; then placing the multi-slot charger 100 on the wall-mounting bracket 115, so that the bottom surface of the multi-slot charger 100 and the bottom panel 1152 of the wall-mounting bracket 115 fit each other and so that the first case 11 and the back panel 1151 fit each other; and finally making bolts pass through the multi-slot charger 100 and connect to the location holes 11501 on the back panel 1151, so that the multi-slot charger 100 is fixed on the wall-mounting bracket 115 and the installation is completed. In exemplary embodiments of the present disclosure, the wall-mounting bracket 115 is not provided, that is, a plurality of slots or openings is directly provided on the first case 11 for clamping and fixing with bolts fixed to the wall.

The present disclosure proposes a multi-slot charger. By configuring multiple charging slots on the charger, multiple battery packs may be charged at the same time, thereby improving the charging efficiency. In addition, the multi-slot charger is configured with two different charging modes, and users may switch between different charging modes to charge the battery pack according to their needs under different circumstances. In addition, a certain distance is provided between each two adjacent charging slots to facilitate the installation of battery packs and avoid interference between two adjacent battery packs.

The present disclosure proposes a multi-slot charger. By providing a first vent and a second vent at the bottom and top of the housing, providing a cooling fan inside the housing, and making the areas of the first vent and the second vent within a suitable range, it is ensured that sufficient air flows through the high-temperature components on the circuit board to improve the ventilation effect and improve the heat dissipation effect of the multi-slot charger.

The present disclosure proposes a multi-slot charger. By providing an angle β between the charging interface and the vertical direction of the multi-slot charger, and making the angle β be within a reasonable range, the cooperative installation between the internal battery pack and the charging interface is very convenient.

The present disclosure proposes a multi-slot charger. The multi-slot charger uses a variety of different ways of placement, so that different ways of placement may be adopted in different usage scenarios. Therefore, the multi-slot charger may be used more rationally.

The present disclosure proposes a multi-slot charger. By providing a handle assembly instead of directly fixing the handle to the first case and/or the second case of the multi-slot charger with screws, the force is prevented from being concentrated on the screw fixation, thereby avoiding the situation that the housing is easily damaged because the force-bearing area is too small. In the present disclosure, the area where the first auxiliary handle and the second auxiliary handle in the handle assembly are connected to the multi-slot charger completely covers and secures the end faces of the first case and the second case of the multi-slot charger and then the handle is connected and fixed. This structure may increase the stressed area and make the whole structure stronger and more reliable.

The above description is only an explanation of exemplary embodiments of the present disclosure and the technical principles used. Those skilled in the art should understand that the scope involved in the present disclosure is not limited to technical solutions formed by a specific combination of the above technical features. In addition, it should also cover other technical solutions formed by any combination of the above technical features or their equivalent features without departing from the concept of the present disclosure, for example, the technical solution formed by replacing the above features with technical features disclosed (but are not limited to) in this disclosure that have similar functions.

Except for the technical features described in the description, the remaining technical features are known to those skilled in the art. To highlight the innovative features of the present disclosure, the remaining technical features will not be described in detail here.

## Claims

1. A multi-slot charger which is placeable in a vertical, horizontal, or wall-mounted manner, comprising:
a housing; and
a handle assembly comprising auxiliary handles provided on two sides of the housing and a lifting handle provided on a top of the housing,
wherein
when the multi-slot charger is placeable in a vertical and/or horizontal manner, the auxiliary handles are configured to support the multi-slot charger, and
when the multi-slot charger is placeable in a wall-mounted manner, a plurality of locking slots is provided on the housing such that the housing is directly connectable to a vertical surface through the plurality of locking slots, or a wall-mounting bracket is installed on the housing such that the housing is able to be mountable to the vertical surface through the wall-mounting bracket.

2. The multi-slot charger according to claim 1, wherein the wall-mounting bracket includes a back panel and a bottom panel, and the back panel is fixedly connected to the bottom panel.

3. The multi-slot charger according to claim 2, wherein the back panel is configured to cover a second case of the housing and the bottom panel is configured to support and cover a bottom surface of the housing.

4. The multi-slot charger according to claim 2, wherein the back panel is provided with location holes near the top of two sides of the back panel, the location holes are located on a same straight line, and the housing is installed on the wall-mounting bracket through the location holes.

5. The multi-slot charger according to claim 2, wherein the back panel is further provided with a plurality of mounting holes, the plurality of mounting holes is evenly distributed on the back panel, and the wall-mounting bracket is installed on the vertical surface through the plurality of mounting holes.

6. The multi-slot charger according to claim 3, wherein the wall-mounting bracket further includes side panels configured to cover the auxiliary handles on two sides of the housing, second bottom surfaces are formed extending inwardly from the side panels, and the second bottom surfaces are configured to support the auxiliary handles.

7. The multi-slot charger according to claim 6, wherein the bottom panel and the second bottom surfaces are all rigid force-bearing surfaces.

8. The multi-slot charger according to claim 3, wherein a plurality of ventilation slots is provided on the bottom panel at intervals, and the plurality of ventilation slots corresponds in a one-to-one manner to vents on a bottom of the housing.

9. The multi-slot charger according to claim 1, wherein the multi-slot charger is provided with a switch, and the switch is configured to control and switch a charging mode of the multi-slot charger.

10. The multi-slot charger according to claim 1, wherein the multi-slot charger further includes a plurality of charging slot indicator lights, and the plurality of charging slot indicator lights being disposed on the top of the housing and located below the lifting handle of the handle assembly.

11. The multi-slot charger according to claim 1, wherein a ratio of a vertical distance between a front side of the auxiliary handle and a midline of the lifting handle to a vertical distance between a rear side of the auxiliary handle and the midline of the lifting handle is between 1 and 3.

12. The multi-slot charger according to claim 1, wherein when a battery pack is installed on the multi-slot charger, a ratio of a total weight of the battery pack to a weight of the multi-slot charger is between 0.1 and 4.

13. The multi-slot charger according to claim 1, wherein the housing is provided with a plurality of charging slots, and each charging slot includes a charging interface and a power supply terminal to match a battery pack.

14. The multi-slot charger according to claim 13, wherein an angle β is set between the charging interface and a vertical direction of the multi-slot charger, and the range of the angle β is 0 ° to 60°.

15. The multi-slot charger according to claim 14, wherein a spacing distance between two adjacent battery packs is provided on the charging interface, and the spacing distance ranges from 3 mm to 100 mm.

16. The multi-slot charger according to claim 13, wherein the housing includes a first case and a second case, the first case and the second case are fixedly connected, the charging slot is located on the first case, and an inner wall of the second case is provided with horizontal and vertical grid-shaped reinforcing ribs.

17. The multi-slot charger according to claim 16, wherein a bottom surface of the multi-slot charger has a slope structure, and a direction of the slope structure is inclined downwardly relative to a direction pointing from the first case to the second case.

18. The multi-slot charger according to claim 17, wherein an angle between the slope structure and the ground is between 3° and 6°, a spacing distance between a lowest point of the slope structure and the ground is between 5 mm and 20 mm.

19. The multi-slot charger according to claim 1, wherein the lifting handle includes a main part and flat structures at two ends, the main part extends toward the housing to form two connecting posts, and each connecting post extends into an interior of the housing and is fixedly connected to the housing through a reinforcing plate, and the flat structures are configured to be fixedly connected to the auxiliary handles on two sides of the housing.

20. The multi-slot charger according to claim 1, wherein the housing is provided with a heat dissipation structure including:
a plurality of first vents provided at a bottom of the housing of the multi-slot charger;
a plurality of second vents provided on the top of the housing, wherein a ratio of an area of the first vent and an area of the second vent is between 1 and 2; and
a plurality of cooling fans provided in the housing and corresponding to the plurality of second vents in a one-to-one manner.
